# EUROPEAN PATENT APPLICATION

(11) **EP 1 523 075 A2**
(43) Date of publication of application: **13.04.2005**
(21) Application number: 04023966.7
(22) Date of filing: 07.10.2004
(51) Int. Cl.: H01S 3/067, H01S 3/30, G02B 6/12

(54) **High power fibre laser with eye safe wavelengths**

(30) Priority: 08.10.2003 US 681441
(71) Applicant: Northrop Grumman Corporation, Los Angeles, CA 90067-2199 (US)
(72) Inventor: Komine, Hiroshi, Torrance, California 90505 (US)
(74) Representative: Paustian, Othmar, Dr.-Ing.

(57) **Abstract**

A relatively high power fiber laser (40) with an output wavelength in a spectral region considered to be "eye-safe" is disclosed. The high power fiber laser (40) includes one or more fiber lasers that are fiber coupled, bundled and tapered into a multi-mode fiber. The multi-mode fiber is coupled into a hollow core, photonic band gap optical fiber (44) filled with a Raman medium. In particular, fiber lasers formed from Yttrebium fibers having a nominal output wavelength of 1060-1120 nanometers are shifted to the eye-safe wavelength range by way of a hollow core photonic bond gap (PBG) filled with deuterium (D₂) gas. Diode lasers (42) having an output wavelength in the range of 940-980 nanometers can also be shifted to an eye-safe wavelength by direct Raman shifting of fiber coupled diode array to a hollow core PBG fiber filled with hydrogen (H₂ gas). The use of the PBG optical fibers (44) filled with various Raman medium for shifting the output wavelength of high power fiber lasers and diode lasers is relatively simple and inexpensive.

## Description

### BACKGROUND OF THE INVENTION

### 1. field of the Invention

The present invention relates to a high power laser system and more particularly to a high power fiber laser system with an output wavelength in the range of 1.5 to 1.6 microns and is thus safe for the human eye.

### 2. Description of the Prior Act

High powered fiber lasers are known to be used in laser weapons systems. Examples of such high powered fiber lasers are disclosed in commonly owned U.S. patent nos: 6,144,677; 6,229,939; 6,366,356; and 6, 404,784. Such high power fiber lasers are also disclosed in commonly owned co-pending U.S, patent application serial no. 09/132,178, filed on August 11, 1998.

In such applications, light is known to become scattered along the beam path of the laser and can exceed eye safety standards. As such, the military requires that such high powered laser weapons emit wavelengths at so called "eye-safe" wavelengths - around 1.5 to 1.6 microns. Known high power fiber lasers, for example, utilizing ytterbium fibers, are known to emit light at a wavelength in the range of 1060-1120 nanometers - outside of the eye-safe range.

In addition to high power fiber laser systems, solid state lasers which use semiconductor laser diodes for pumping are also of concern. Examples of such solid state laser systems are disclosed in U.S. patent nos. 6,404,784; 6,301,277; 6,219,360; 5,796,761; 5,790,575; 5,748,654 and 5.555,254. Such solid State lasers normally include a solid statx lasing material. Semiconductor laser diodes are used as a pump source in order to raise the solid state lasing material to a relatively high energy state. Such semiconductor laser diodes are known to emit laser light at output wavelengths of 940-980 nanometers - also outside of the range of so-called "eye-safe wavelengths."

Different techniques are known to be used to shift the frequency of the output of a fiber or semiconductor laser diode to be within the so-called eye-safe wavelength range. For example, stimulated Raman scattering (SRS) techniques are known to be used to shift the output wavelength of both fiber and semiconductor diode lasers. SRS involves coupling an incident light beam to a so-called Rarnan medium which scatters incident light beam at a different frequency. The scattered light beam will have a lower frequency (and longer wavelength) than the incident light beam if the Raman medium is initially in its ground state. The scattered light beam is termed a Stokes wave. The scattered light beam will have a higher frequency (and shorter wavelength) than the incident light beam if the Raman medium is initially in an excited state. In this case, the scattered light beam is termed an anti-Stokes wave.

The first generated light beam can act as a pump for a second Stokes wave in a second stimulated Raman interaction. Still higher order Stokes waves may also be generated in this same manner. The frequency of each of the second and higher order waves is shifted from that of the first Stokes wave. Accordingly, SRS is a useful technique to produce several wavelengths from a Raman medium by utilizing different Raman shifts. These higher order wavelengths are not always desirable, however, because they lower the intensity of the first Stokes wave and detract from producing the desired output beam intensity.

It is also known to use SRS to shift the wavelength of a fiber laser to an "eye-safe" wavelength. In particular, in known systems the output beam -from the fiber laser is coupled to a fiber core, formed from a Raman medium, such as silica glass. In such an embodiment, the fiber is normally several kilometers in length. In addition, multiple frequency shifts are necessary to achieve the desired output wavelength because the shift in silica glass is relatively small.

U.S. Patent No. 5,796,761 discloses a laser system which utilizes stimulated Raman scattering to shift the frequency of a solid state lasing system for a particular application. In particular, the 761 patent discloses the use of a solid Raman medium, such as crystalline calcium tungstate, to shift the frequency of a laser diode pumping system for a solid state laser system. Unfortunately, the Raman medium disclosed in the '761 patent is not suitable for shifting the frequency of the output wavelength of diode lasers having a output wavelength in the range of 940-980 nanometers to an eye-safe wavelength, as discussed above. Thus, there is a need for a relatively simple technique for shifting the output wavelength of relatively high-powered fiber lasers and diode lasers to an eye-safe wavelength.

### SUMMARY OF THE INVENTION

Briefly, the present invention relates to a relatively high power fiber laser with an output wavelength in a spectral region considered to be "eye-safe". The high power fiber laser includes one or more fiber lasers that are fiber coupled, bundled and tapered into a multi-mode fiber. Stimulated Raman scattering (SRS) is used to shift the wavelength of the fiber laser to an "eye-safe" wavelength. In particular, the multi-mode fiber is coupled into a hollow core, photonic band gap (PBG) optical fiber filled with a Raman medium. In accordance with an important aspect of the invention, fiber lasers formed from yttrebium fibers having a nominal output wavelength of 1060-1120 nanometers are shifted to the eye-safe wavelength range by way of a hollow core photonic band gap (PBG) fiber filled with deuterium (D₂) gas Diode lasers having an output wavelength in the range of 940-980 nanometers are shifted to an eye-safe wavelength by SRS by coupling the output beams of the fiber coupled diode array to a hollow core PBG fiber filled with hydrogen (H₂ gas). The use of the PBG optical fibers filled with various Raman mediums for shifting the output wavelength of high power fiber lasers and diode lasers is relatively simple and inexpensive.

### DESCRIPTION OF THE DRAWINGS

These and other advantages of the present invention should be readily understood with reference to the following specification and attached drawing where:

Figure 1 is a simplified diagram of the invention which illustrates Raman shifting of a fiber coupled diode array and a Ytterbium (Yb) fiber laser superimposed on a graph to illustrate the shift in wavelength to the "eye-safe" spectral region.

Figure 2A is a schematic diagram of the diode laser with a shifted output wavelength in accordance with the present invention.

Figure 2B is similar to Figure 2A but illustrates a diode laser with an amplified output with a shifted output wavelength in accordance with the present invention.

Figure 3 illustrates a schematic diagram of a fiber laser with a shifted output wavelength in accordance with the present invention.

### DETAILED DESCRIPTION

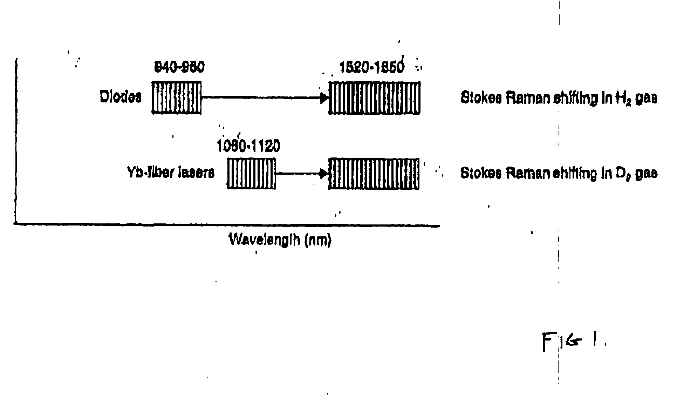

The present invention relates to a technique for shifting the output of a relatively high power fiber laser as well as a diode laser to an eye-safe wavelength. Both embodiments of the invention are based on stimulated Raman scattering (SRS). Fiber lasers formed from Ytterbium (Yb) are known to have a nominal output wavelength in the range of 1060-1120 nanometers, while semiconductor-diode lasers are known to have an output wavelength in the range of 940-980 nanometers. As illustrated in FIG. 1, the output wavelength of the Yb fiber lasers and semiconductor diode lasers is shifted to a wavelength in the "eye-safe" spectral region, 1520-1650 nanometers, in accordance with the present invention.

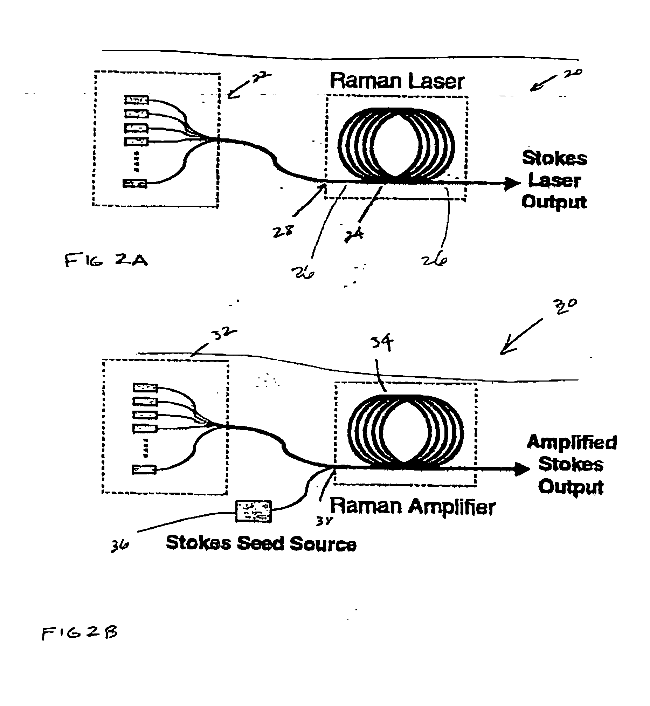

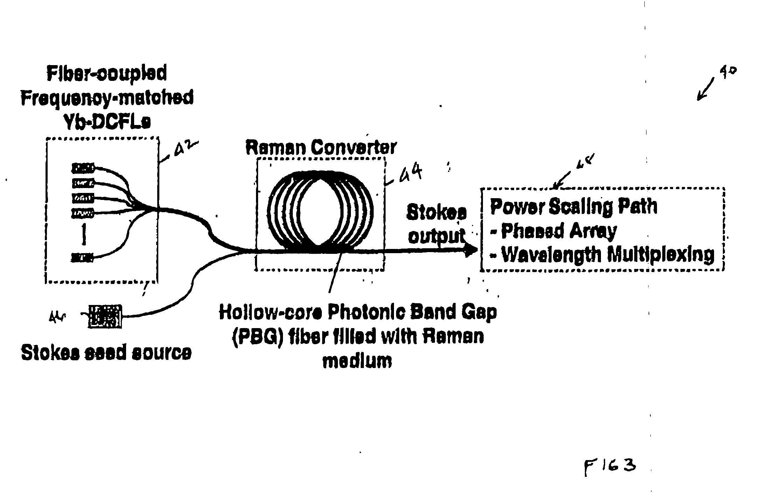

FIGS. 2A and 2B illustrate stimulated Raman scattering of a semiconductor laser diode. In particular, FIG. 2A illustrates the application of the invention to a semiconductor laser diode configured as a fiber coupled diode array. FIG. 2B is similar to FIG. 2A but includes an external Stokes seed source to form a laser amplifier. FIG. 3 illustrates an alternative embodiment of the invention which relates to stimulated Raman scattering of a Yb fiber amplifier. All embodiments of the invention utilize a hollow core photonic band gap (PBG) fiber filled with a Raman medium. In the case of the semiconductor diode arrays illustrated in Figures 2A and 2B, the Raman medium is hydrogen H₂ gas. In the case of the Yb fiber lasers, the Raman medium is deuterium D₂ gas.

Referring first to Figure 2A, a Raman laser, generally identified with the reference numeral 20, is illustrated. As mentioned above, the Raman laser 20 in accordance with the present invention relies on stimulated Raman scattering to shift the nominal output wavelength range of a fiber coupled diode array having an output wavelength in the range of 940-980 nanometers to an eye safe wavelength. The Raman laser 20 includes a fiber coupled diode array 22 coupled to a hollow core photonic band gap fiber 24 filled with a Raman medium and optical feedback sections 26 at each end. In the case of a diode array having a nominal output wavelength of 940 nanometers, the use of hydrogen H₂ gas will provide an output wavelength of about 1540 nanometers.

Fiber coupled diode arrays 22 are well known in the art. Examples of such fiber coupled diode arrays are disclosed in U.S. patent nos. 5,675,685 and 6,377,410 as well as commonly owned U.S. patent no. 6,229,939. Examples of such fiber coupled arrays are also disclosed in "Coupling of High Power Diode Laser Arrays and Fibers" by Lina Li, Proceedings SPIE, vol. 4225, pgs. 201-203, October 2000 and "Fiber Coupling of Laser Diode Arrays for High Brightness: Planning Considerations" by Skutnik, et al., Proceedings SPIE Vol. 4629, pgs. 86-93, June 2002. The particular type of fiber coupled diode array is unimportant. It is only important that the output wavelength of the fiber coupled diode array 22 be in the range of 940-980 nanometers. An example of fiber coupled diode arrays having an output wavelength in the range of 940-980 nanometers is a model no. LDF-400, as manufactured by Laserline GmbH (www.laserline.de).

The output of the fiber coupled diode array 22 is optically coupled to a hollow core photonic band gap (PBG) fiber 24, filled with H₂ gas. Such hollow core PBG fibers are generally known in the art. Examples of such PBG hollow core fibers are disclosed in "Stimulated Raman Scattering in Hydrogen Filled Hollow Core Photonic Crystal Fiber" by Benabid, et al., Science Magazine Vol. 298, No. 5592, October 11, 2002, pgs. 399-402. Such hollow core photonic band gap fibers may currently be custom ordered from Crystal Fibre A/S (www.crystal-fibre.com). With a nominal gas density of 2 atmospheres and a core diameter of the hollow core of 100 micrometers, the output wavelength of the Raman laser 20 illustrated m FIG. 2A will be 1540 nanometers and thus within the "eye-safe" spectral region.

The interface between the diode array 22 and the hollow core PBG fiber is identified with the reference numeral 28. The interface consists of a fusion splice between the PBG fiber 34 and a tapered multimode fiber bundle having approximately the same size.

Figure 2B is similar to Figure 2A but illustrates a laser amplifier 30 with a shifted output wavelength. The laser amplifier includes a fiber coupled diode array 32. The fiber coupled diode array 32 is similar to the fiber coupled diode array 22 and is configured to have a nominal output wavelength of 940 nanometers. The fiber coupled diode array 32 is coupled to a hollow core PBG fiber 34 filled with hydrogen H₂ gas. In order to amplify the output from the fiber coupled diode array 32, a Stokes seed source is also applied to the hollow core PBG fiber 34.

Both the output of the fiber coupled diode array 32 and the Stokes seed source 36 are coupled to the hollow core PBG fiber by way of an interface 38. The output of the fiber coupled array 32 acts as a pump source to cause amplification of the Stokes seed source 36. The Stokes seed source 36 may be for example a erbium-doped fiber laser having an output wavelength of 1540 nanometers. An exemplary seed source 36 is commercially available as ELR Series (e.g., ELR-10) from IPG Photonics Corporation (www.ipgphotonics.com).

An exemplary characteristics for a Raman amplifier 30 in accordance with the present invention are illustrated in Table 1 below.

**Table 1**

| Exemplary Raman Amplifier Characteristics | |
|---|---|
| Diode wavelength | 940 nm. |
| Stokes wavelength | 1540 nm. |
| Raman medium H₂ gas | |
| Gas Density | 2 atm. |
| Core diameter | 100 microns |
| Fiber length - | |
| 50 W pump | 200 m |
| 1 KW pump | 10 m |
| Amplifier Gain | 40 dB |
| Quanrum efficiency | 60% |

A Raman laser which shifts the output wavelength of Yttrebium (Yb) fiber coupled laser to an "eye-safe" spectral region is illustrated in FIG. 3 and identified with the reference numeral 40. The Raman laser 40 includes a fiber coupled frequency matched diode array 42 and a Raman convener 44. A Stokes seed source 46 may be optionally applied to the Raman converter 44 to form a Raman amplifier.

The present invention also applies to frequency matched Yb fiber coupled diode arrays having an output wavelength in the range of 1060-1120 nm. Such frequency matched Yb fiber coupled diode arrays are known in the an. Examples of commercially available fiber coupled frequency matched Yb fiber arrays 42 are available as PYL Series (e.g. PYL-50 for 50 watt output power) from IPG Photonics Corporation.

The Raman convener 44 is a hollow core photonic band gap fiber filled with a Raman medium. In this case, the Raman medium is deuterium (D₂) gas. The density of the deuterium (D₂) gas is for example, 2-4 atmospheres. The core diameter of the hollow core PBG fiber which forms the cavity for the deuterium (D₂) may be for example, 10 to 100 microns, depending on the pump power and beam brightness of the Yb fiber laser.

Embodiments without the Stokes seed source 46 form a Raman laser 40, with an output wavelength in the range of 1520- 1650 nm. In embodiments which incorporate a Stokes seed source, a Raman amplifier is formed having an output wavelength also in the "eye-safe" spectral range. The output of the Raman laser/Ratrian amplifier can be scaled by techniques based upon wavelength multiplexing. For example, the shifted wavelength output can be shifted again utilizing SRS.

Obviously, many modifications and variations of the present invention are possible in light of the above teachings. Thus, it is to be understood that, within the scope of the appended claims, the invention may be practiced otherwise than as specifically descnbed above.

What is claimed and desired to be covered by a Letters Patent is as follows:

## Claims

1. A method for shifting the output wavelength of a laser system having an output with a nominal output wavelength to an eye-safe wavelength
(a) providing a hollow core photonic band gap (PBG) fiber;
(b) filling the hollow core PBG fiber with a gas selected to shift the nominal output wavelength of the laser system to a predetermined value; and
(c) applying the output of said laser system to said hollow core PBG fiber.

2. The method as recited in claim 1, wherein step (c) comprises:
applying the output of a Yb fiber laser system having a nominal output wavelength in the range of 1060-1120 nm to said hollow core PBG fiber.

3. The method as recited in claim 2, wherein step (b) comprises filling the hollow core PBG with D₂ gas.

4. The method as recited in claim 1, wherein step (c) comprises applying the output of a diode laser having a nominal output in the range of 940-980 nm to said hollow core PBG fiber.

5. The method as recited in claim 4, wherein step (b) comprises filling the hollow core PBG fiber with H₂ gas.

6. A Raman laser having an eye-safe output wavelength, the Raman laser comprising:
a fiber coupled diode array having a nominal output wavelength in the range of 940-980 nm; and
a hollow core photonic band gap (PBG) fiber filled with H₂ gas, coupled to the output of said fiber coupled diode array.

7. The Raman laser recited in claim 6, further including a Stokes seed source coupled to said hollow core PBG fiber forming a Raman amplifier.

8. A Raman laser having an eye-safe output wavelength, the Raman laser comprising;
a Yb fiber coupled frequency matched diode array having a nominal output wavelength in the range of 1060-1120 nm; and
a hollow core photonic band gap fiber filled with D₂ gas, coupled to the output of said fiber coupled diode array.

9. The Raman laser as recited in claim 8, further including a Stokes seed source coupled to said hollow core PBG fiber forming a Raman amplifier.
